# EUROPÄISCHE PATENTANMELDUNG

(11) **EP 1 132 743 A2**
(43) Veröffentlichungstag der Anmeldung: **12.09.2001**
(21) Anmeldenummer: 00128762.2
(22) Anmeldetag: 30.12.2000
(51) Int. Cl.: G01P 15/00, B81B 3/00

(54) **Mikromechanisches Bauelement**

(30) Priorität: 07.03.2000 DE 10010975
(71) Anmelder: ROBERT BOSCH GMBH, 70442 Stuttgart (DE)
(72) Erfinder: Niendorf, Andreas, 12527 Berlin (DE); Funk, Karsten, Mountain View, CA 94041 (US)

(57) **Zusammenfassung**

Die Erfindung schafft ein mikromechanisches Bauelement mit einem Substrat (1) und einer elastisch mit dem Substrat (1) über eine Federeinrichtung (15; 16, 17) verbundenen Schwungmasse (5); wobei die Schwungmasse (5) mindestens einen ersten und einen zweiten Schwingungsmode eingehen kann. Eine Dämpfungseinrichtung (10; 19, 20; 25, 26; 100, 110) zur selektiven Dämpfung eines der Schwingungsmoden aus einem elastischen, flüssigen oder gasförmigen Medium ist vorgesehen.

## Beschreibung

### STAND DER TECHNIK

Die vorliegende Erfindung betrifft ein mikromechanisches Bauelement mit einem Substrat und einer elastisch mit dem Substrat über eine Federeinrichtung verbundenen Schwungmasse, wobei die Schwungmasse mindestens einen ersten und einen zweiten Schwingungsmode eingehen kann.

Obwohl prinzipiell auf beliebige mikromechanische Bauelemente anwendbar, werden die vorliegende Erfindung sowie die ihr zugrundeliegende Problematik in bezug auf mikromechanische Beschleunigungssensoren erläutert.

Mikromechanische Bauelemente sind im allgemeinen Masse-Feder-Systeme mit einem typischem Resonanzverhalten. Diese zeigen jedoch neben der gewünschten Frequenz bzw. Nutzfrequenz eines bestimmten Freiheitsgrades auch häufig unerwünschte und ungedämpfte Resonanzfrequenzen in den anderen Freiheitsgraden.

An Federn aufgehangene Massen haben 6 Freiheitsgrade. Die Federn weisen dabei bezüglich der Freiheitsgrade unterschiedliche Federkonstanten auf. Diese führen zu den unterschiedlichen Resonanzfrequenzen. Oft setzten sich die Federn auch aus kombinierten Federn zusammen. Meist ist nur die Schwingung um einen Freiheitsgrad als Nutzschwingung erwünscht.

In der Literatur wurde bisher sehr ausgiebig die Dämpfung der Luft untersucht. Diese ist jedoch in den meisten Fällen unerwünscht, da sie die Güte aller Moden ändert, und nicht nur diejenige der unerwünschten Moden.

### VORTEILE DER ERFINDUNG

Das erfindungsgemäße mikromechanische Bauelement mit den Merkmalen des Anspruchs 1 weist gegenüber bekannten Lösungsansätzen den Vorteil auf, daß unerwünschte Resonanzfrequenzen gedämpft werden können und so ein besseres Verhalten des Gesamtsystem erreichbar ist. Insbesondere kann die Stabilität und das Verhältnis der erwünschten Resonanzfrequenz zu den unerwünschten verbessert werden.

Die der Erfindung zugrundeliegende Idee ist es, einzelne Federelemente so zu bedämpfen, dass nur bestimmte Freiheitsgrade gedämpft werden, die erwünschte Schwingung jedoch nicht bedämpft wird. Es ist jedoch auch eine Bedämpfung des gesamten System denkbar, wenn die hohe Güte des Siliziums unerwünscht ist. Des weiteren sollen die Bedämpfungen unerwünschte Resonanzfrequenzen unabhängig vom Freiheitsgrad dämpfen.

Der Kern der Erfindung besteht darin, die dämpfenden Eigenschaften von elastischen, flüssigen oder gasförmigen Stoffen in Mikrosystemen zu nutzen, um gezielt unerwünschte Moden zu dämpfen. Dabei wird der dämpfende Stoff durch die Bewegung verformt und wandelt die Verformungsenergie in Wärme um. Durch ein geeignetes Design kann eine unterschiedliche Dämpfung in den unterschiedlichen Freiheitsgraden erreicht werden.

Besondere Vorteile sind:
- eine Verbesserung von bestehenden Sensorkonzepten hinsichtlich ihres Resonanzverhaltens,
- eine Verbesserung von Stör-, Nutzsignalabständen,
- eine Erhöhung der Empfindlichkeit und Zuverlässigkeit von Sensoren oder Aktoren
- eine bessere Stoßfestigkeit durch Energieaufnahme

In den Unteransprüchen finden sich vorteilhafte Weiterbildungen und Verbesserungen des in Anspruch 1 angegebenen Gegenstandes der Erfindung.

Gemäß einer bevorzugten Weiterbildung weist die Dämpfungseinrichtung eine elastische Schicht auf, welche auf die Oberfläche des Substrats und/oder der Federeinrichtung und/oder der Schwungmasse aufgebracht ist. Solch eine Struktur ist leicht und genau herstellbar.

Gemäß einer weiteren bevorzugten Weiterbildung ist der eine Schwingungsmode ein Nutzmode und der andere Schwingungsmode ein Störmode und ist die Dämpfungseinrichtung derart gestaltet, daß sie den Störmode dämpft.

Gemäß einer weiteren bevorzugten Weiterbildung ist die Dämpfungseinrichtung ein Reservoir, in das eine elastische Masse eingebracht ist. Die elastische Masse kann hochviskos oder härtbar sein.

Gemäß einer weiteren bevorzugten Weiterbildung ist das Reservoir im Substrat vorgesehen.

Gemäß einer weiteren bevorzugten Weiterbildung ist das Reservoir zur Federeinrichtung hin offen.

Gemäß einer weiteren bevorzugten Weiterbildung weist die Federeinrichtung eine am Substrat vorgesehene u-förmige Feder und eine daran vorgesehene längsbalkenförmige Feder auf.

Gemäß einer weiteren bevorzugten Weiterbildung weist die Dämpfungseinrichtung ein Kanalsystem auf, in das eine Flüssigkeit eingebracht ist.

Gemäß einer weiteren bevorzugten Weiterbildung weist die Dämpfungseinrichtung eine Kammstruktur auf, in das ein Gas eingebracht ist.

### ZEICHNUNGEN

Ausführungsbeispiele der Erfindung sind in den Zeichnungen dargestellt und in der nachfolgenden Beschreibung näher erläutert.

Es zeigen:
- Fig. 1: einen Ausschnitt eines mikromechanischen Bauelements als erste Ausführungsform der vorliegenden Erfindung;
- Fig. 2a,b: die Amplitudenverläufe über der Frequenz für die erste Ausführungsform, und zwar Fig. 1a für den ungedämpften Fall und Fig. 2b für den gedämpften Fall;
- Fig. 3a,b,c: einen Ausschnitt eines mikromechanischen Bauelements als zweite Ausführungsform der vorliegenden Erfindung;
- Fig. 4: einen Ausschnitt eines mikromechanischen Bauelements als dritte Ausführungsform der vorliegenden Erfindung; und
- Fig. 5: einen Ausschnitt eines mikromechanischen Bauelements als vierte Ausführungsform der vorliegenden Erfindung.

### BESCHREIBUNG DER AUSFÜHRUNGSBEISPIELE

In den Figuren bezeichnen gleiche Bezugszeichen gleiche oder funktionsgleiche Elemente.

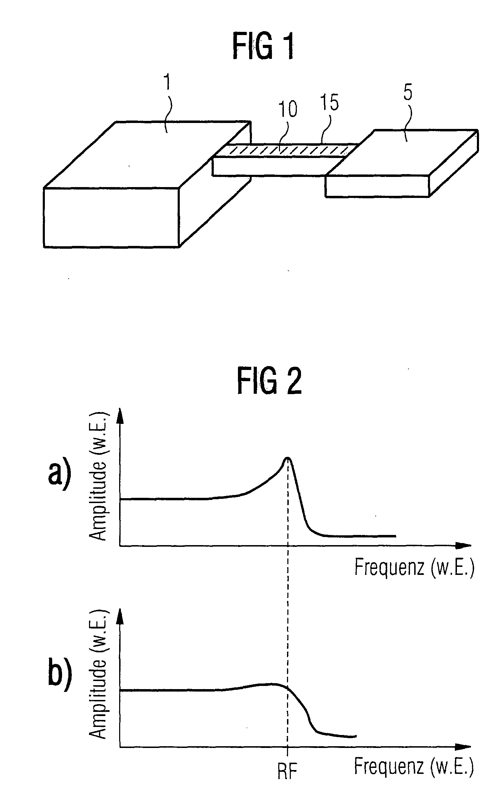

Fig. 1 zeigt einen Ausschnitt eines mikromechanischen Bauelements als erste Ausführungsform der vorliegenden Erfindung.

In Fig. 1 bezeichnet 1 ein Siliziumsubstrat mit einer daran vorgesehenen Biegefeder 15 und einer an der Biegefeder 15 angebrachten Schwungmasse 5.

Die hier vorgesehene Möglichkeit zur Dämpfung ist das Aufbringen einer elastischen Schicht 10 auf die zu bedämpfende Struktur, im speziellen Fall auf die Biegefeder 15. Dabei kommen z.B. Polymere in Betracht oder andere elastische Materialien. Diese sollen durch mechanische Verformung die Schwingungsenergie aufnehmen und in Wärme umwandeln, ohne jedoch die eigentliche Funktion des Masse-Feder-Systems zu beeinflussen. Ein Vorteil besteht darin das auch sehr kleine Strukturen gezielt bedämpft werden können.

Fig. 2a,b zeigen die Amplitudenverläufe über der Frequenz für die erste Ausführungsform, und zwar Fig. 1a für den ungedämpften Fall und Fig. 2b für den gedämpften Fall.

Ein Beschleunigungssensor, der die in Fig. 1 dargestellte Struktur hat, weist nach dem Masse-Feder-Prinzip eine typische Resonanzfrequenz RF auf. Diese kann mit Hilfe der bedämpfenden Schicht 10 bedämpft werden, ohne das die Empfindlichkeit des Sensors in dem unteren Frequenzbereich stark beeinflußt wird. Durch diese Dämpfung kann der Einsatzbereich des Sensors erweitert werden, und die Stoßempfindlichkeit kann verringert werden.

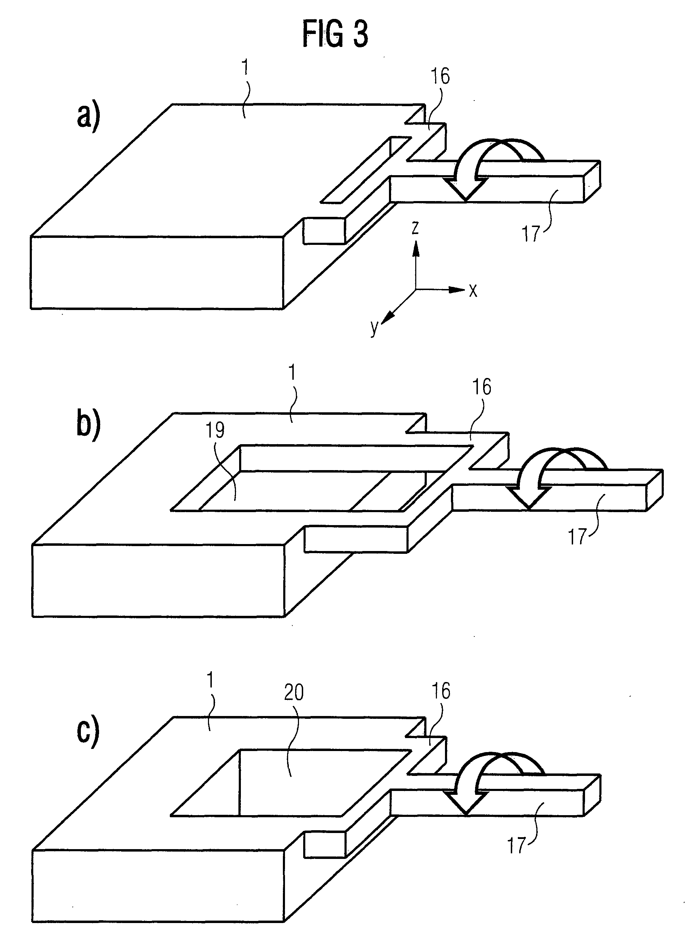

Fig. 3a,b,c zeigen einen Ausschnitt eines mikromechanischen Bauelements als zweite Ausführungsform der vorliegenden Erfindung.

Wie erläutert, wird allgemein durch Aufbringen oder Einbringen von elastischen Stoffen auf oder in einer Struktur wird die gewünschte Dämpfung erreicht. Dabei kann es sich auch um einen flüssigen Stoff handeln, der nach Einbringen zu einer elastischen Masse abbindet oder erstarrt oder um einen elastischen Stoff, der in die Struktur eingebracht wird und in seiner chemischen Struktur erhalten bleibt.

Die in Fig. 3a gezeigte Federkonstruktion weist durch die Verwendung zwei senkrecht zueinander angebrachter Biegefedern 16, 17 eine relativ geringe Federkonstante in x-Richtung auf.

Diese kann jedoch zu einem verzerrten Schwingverhalten der in Fig. 3 nicht dargestellten Schwingmasse führen. Durch das Einbringen von einer elastischen Masse 20 in ein Reservoir 19 wird die Schwingung in der x-Richtung und y-Richtung bedämpft. Das Reservoir 19 kann gleichzeitig mit dem Freiätzen der Schwingstrukturen hergestellt werden. Die erste u-förmige Feder 16 hat die Aufgabe die zweite längsbalkenartige Feder 17 mechanisch zu entlasten. Dabei sollte sie möglichst weich sein, das Schwingverhalten nicht beeinflussen. Der Vorteil dieser Konstruktion besteht nun darin, daß die erste Feder 17 durch die Dämpfung wesentlich weicher gestaltet werden kann, ohne das Schwingverhalten stark zu beeinflussen.

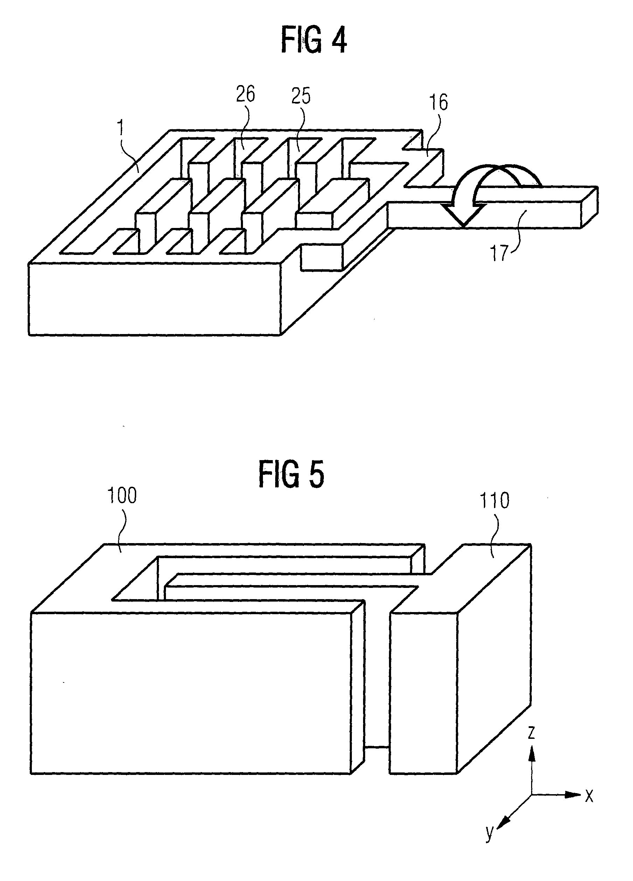

Fig. 4 zeigt einen Ausschnitt eines mikromechanischen Bauelements als dritte Ausführungsform der vorliegenden Erfindung.

Eine weitere Möglichkeit besteht darin, Flüssigkeiten zur Dämpfung zu verwenden. Diese Flüssigkeit kann direkt an die gewünschte Stelle eingebracht werden oder bei sehr kleinen Strukturen durch Kapillarwirkung an die gewünschte Stelle geleitet werden. Wird das System zu Schwingungen angeregt, dann wird in der Flüssigkeit abwechselnd ein Überdruck bzw. Unterdruck erzeugt der zur Dämpfungskräften führt.

Insbesondere für die Struktur kann die Flüssigdämpfung eingesetzt werden. Dabei wird zwischen der Feder 16 und dem Substrat 1 eine Flüssigkeit 25 in eingeätzte Kanäle 26 eingebracht. Aufgrund der Kapillarwirkung wird diese zwischen der Feder und dem Substrat festgehalten. Um eine einfache Dosierung zu erreichen, wird die Flüssigkeit 25 über ein Kapillarsystem zu ihrem Bestimmungsort geleitet. Die zuführenden Kanäle 26 müssen dabei eine schwächere Kapillarwirkung aufweisen, damit die Flüssigkeit 25 nach dem Befüllen des Reservoirs zu ihrem Bestimmungsort fließt. Die dämpfende Wirkung erfolgt dann analog wie bei der zweiten Ausführungsform.

Fig. 5 zeigt einen Ausschnitt eines mikromechanischen Bauelements als vierte Ausführungsform der vorliegenden Erfindung.

In Fig. 5 bezeichnet 100 eine feststehenden Kammstruktur und 110 eine bewegliche Kammstruktur.

Auch Luft oder ein anderes Gas kann zur gezielten Dämpfung verwendet werden. Dies ist bei der vierten Ausführungsform realisiert.

Dabei werden allgemein zusätzliche Strukturen an der schwingenden Struktur angebracht, die eine Dämpfung in der erwünschten Richtung ermöglichen. Durch Gegenüberstellen von festen Strukturen kann die Luftdämpfung noch wesentlich erhöht werden.

Eine einfache Luftdämpfung kann erreicht werden, indem die in Fig. 5 gezeigte Kammstruktur verwendet wird. Durch die kleinen Abstände zwischen den Kammstrukturen 100, 110 besteht eine große Luftdämpfung. Bewegungen in y-Richtung und Torsionen um die z-Achse werden gedämpft. Bewegungen in x-oder z-Richtung und Torsionen um die y-Achse werden wesentlich weniger gedämpft.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Insbesondere ist die Erfindung nicht auf Beschleunigungssensoren beschränkt, sondern auf beliebige mikromechanische Bauelemente und beliebige Grundmaterialien anwendbar.

## Patentansprüche

1. Mikromechanisches Bauelement mit:
einem Substrat (1); und
einer elastisch mit dem Substrat (1) über eine Federeinrichtung (15; 16, 17) verbundenen Schwungmasse (5);
wobei die Schwungmasse (5) mindestens einen ersten und einen zweiten Schwingungsmode eingehen kann;
**dadurch gekennzeichnet**, daß
eine Dämpfungseinrichtung (10; 19, 20; 25, 26; 100, 110) zur selektiven Dämpfung eines der Schwingungsmoden aus einem elastischen, flüssigen oder gasförmigen Medium vorgesehen ist.

2. Mikromechanisches Bauelement nach Anspruch 1, **dadurch gekennzeichnet, daß** die Dämpfungseinrichtung (10; 19, 20; 25, 26; 100, 110) eine elastische Schicht (10) aufweist, welche auf die Oberfläche des Substrats (1) und/oder der Federeinrichtung (15) und/oder der Schwungmasse (5) aufgebracht ist.

3. Mikromechanisches Bauelement nach Anspruch 1 oder 2, **dadurch gekennzeichnet, daß** der eine Schwingungsmode ein Nutzmode und der andere Schwingungsmode ein Störmode ist und daß die Dämpfungseinrichtung (10; 19, 20; 25, 26; 100, 110) derart gestaltet ist, daß sie den Störmode dämpft.

4. Mikromechanisches Bauelement nach Anspruch 1, **dadurch gekennzeichnet, daß** die Dämpfungseinrichtung (10; 19, 20; 25, 26; 100, 110) ein Reservoir (19), in das eine elastische Masse (20) eingebracht ist.

5. Mikromechanisches Bauelement nach Anspruch 4, **dadurch gekennzeichnet, daß** das Reservoir (19) im Substrat (1) vorgesehen ist.

6. Mikromechanisches Bauelement nach Anspruch 5, **dadurch gekennzeichnet, daß** das Reservoir (19) zur Federeinrichtung (16, 17) hin offen ist.

7. Mikromechanisches Bauelement nach Anspruch 6, **dadurch gekennzeichnet, daß** die Federeinrichtung (16, 17) eine am Substrat (1) vorgesehene u-förmige Feder (16) und eine daran vorgesehene längsbalkenförmige Feder (17) aufweist.

8. Mikromechanisches Bauelement nach Anspruch 1, **dadurch gekennzeichnet, daß** die Dämpfungseinrichtung (10; 19, 20; 25, 26; 100, 110) ein Kanalsystem (26) aufweist, in das eine Flüssigkeit (25) eingebracht ist.

9. Mikromechanisches Bauelement nach Anspruch 1, **dadurch gekennzeichnet, daß** die Dämpfungseinrichtung (10; 19, 20; 25, 26; 100, 110) eine Kammstruktur (100, 110) aufweist, in das ein Gas eingebracht ist.
